(19) Europäisches Patentamt
European Patent Office
Office européen des brevets

(11) **EP 3 809 396 A1**

(12) **EUROPEAN PATENT APPLICATION**
published in accordance with Art. 153(4) EPC

(43) Date of publication:
**21.04.2021 Bulletin 2021/16**

(21) Application number: **19846830.8**

(22) Date of filing: **18.07.2019**

(51) Int Cl.:
***G09B 9/052*** (2006.01)        ***G06F 3/01*** (2006.01)
***G09B 19/00*** (2006.01)

(86) International application number:
**PCT/JP2019/028221**

(87) International publication number:
**WO 2020/031647 (13.02.2020 Gazette 2020/07)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **08.08.2018   JP 2018149509
03.10.2018   JP 2018188459**

(71) Applicants:
• **Softether Corporation
Tsukuba-shi, Ibaraki, 305-0005 (JP)**
• **HONDA MOTOR CO., LTD.
Minato-ku
Tokyo 107-8556 (JP)**

• **University of Tsukuba
Ibaraki 305-8577 (JP)**

(72) Inventors:
• **KUWANA, Junpei
Tsukuba-shi, Ibaraki 305-0005 (JP)**
• **ONO, Hiroshi
Tokyo 107-8556 (JP)**
• **ITO, Makoto
Tsukuba-shi, Ibaraki 305-8577 (JP)**

(74) Representative: **Herzog, Markus
Weickmann & Weickmann
Patent- und Rechtsanwälte PartmbB
Postfach 860 820
81635 München (DE)**

(54)   **DRIVING SIMULATOR AND VIDEO CONTROL DEVICE**

(57)   A driving simulator with which a person with impaired vision can accurately recognize danger at driving and influence of a visual field loss on driving can be experienced is provided. A controller (6) of this driving simulator (1) executes simulated video display control to store visual field loss information data of a user M and simulated video data and display the simulated video data on a screen (8). The controller (6) stores association video data in which a viewpoint O of the user M, the visual field loss information data, and a video of an object in the simulated video data are associated with one another being centered at the viewpoint O of the user M in an identical video during execution of the simulated video display control, and performs playback display of the association video data on the screen (8) after end of the simulated video display control.

FIG.8

**Description**

Technical Field

The present invention relates to a driving simulator or the like with which vehicle driving is experienced in a simulated manner.

Background Art

Conventionally, a technology disclosed in Patent Literature 1 has been known as a driving simulator. In a case of the driving simulator, when a user wears a glasses-type device, a vision impaired simulation mode is executed as a simulated driving travel mode. In the vision impaired simulation mode, an unimpaired user experiences, in a simulated manner, a state in which a person (hereinafter referred to as a "person with impaired vision") suffering a visual field loss due to glaucoma and having impaired vision drives a four-wheel vehicle.

During execution of the vision impaired simulation mode, a shutter of one of glass units on the left and right eye sides in the glasses-type device is opened, and simultaneously, a shutter of the other glass unit is closed and visual failure image data is displayed in this shutter. Accordingly, the user visually recognizes a normal image with one eye and simultaneously visually recognizes, with the other eye, an image similar to an image visually recognized by a person with impaired vision.

In addition, Patent Literature 2 discloses a technology with which, when driving is virtually experienced with a drive simulator, a user of a vehicle can experience a tuning effect before actual traveling by changing control data of the drive simulator in accordance with change (vehicle tuning) of a control characteristic desired by the user.

Citation List

Patent Literature

Patent Literature 1: Japanese Patent Laid-Open No. 2017-217226
Patent Literature 2: Japanese Patent Laid-Open No. 2009-174879

Summary of Invention

Technical Problem

Typically, when actually driving a vehicle, a person with impaired vision visually recognizes a traffic state on the front side of the vehicle while exerting a brain complement function called filling-in. Thus, when the person with impaired vision experiences the vision impaired simulation mode with the above-described driving simulator of Patent Literature 1, the person obtains a view different from a view obtained when the person is actually driving, and thus potentially does not think that a visually recognized state at the experience is the visually recognized state of the person at driving. This leads to a problem that the person with impaired vision cannot accurately recognize danger of the user at driving. Not only a driving simulator but also a device with which a person with impaired vision can accurately recognize danger due to the impaired vision has been desired.

Check of the cognitive function in automobile driving has been stepped-up for elderly people who are 75 years old or over. Cognitive function examination is mandatory when an elderly person renews a driving license. In addition, even at timings other than license renewal, elderly drivers are required to take a cognitive function examination in case of violating any of 18 established items, such as ignoring a traffic light and wrong-way driving, which are likely to be caused when the cognitive function is degraded. An elderly person having passed the cognitive function examination has, by using a driving simulator at an elderly person lecture, a check for physical capabilities and the like necessary for driving.

Although examination related to the cognitive function is performed on an elderly person who drives, examination related to eyes is limited to eyesight examination, and examination related to visual field failure due to eye disease is not performed. With visual field failure (visual field loss or visual field narrowing), part of the visual field has low visibility or is lost because of disease such as glaucoma, retina pigment denaturation, age-related macular denaturation, or brain blood vessel failure. The position of the low visibility or loss in the visual field largely differs between individuals, and the position and degree of visual field narrowing, in other words, a visual field loss vary in various manners. A serious visual field loss is recognizable by the person, but a mild visual field loss is unlikely or difficult to be recognized in some cases.

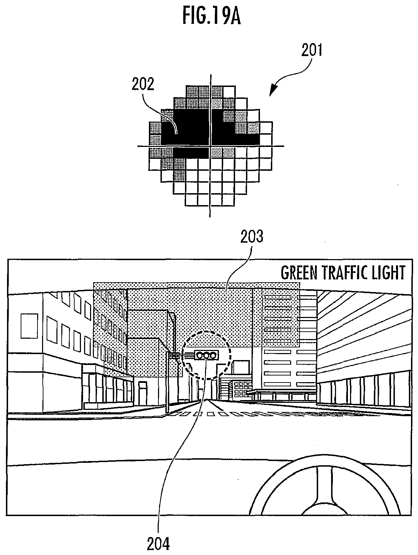

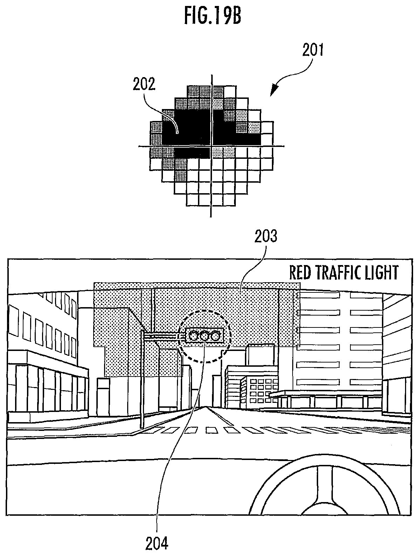

FIG.s 19A and 19B are explanatory diagrams of an exemplary visual field loss, FIG. 19A is an explanatory diagram of a state in which a traffic light is not included in the visual field loss, and FIG. 19B is an explanatory diagram of a state in which the traffic light is included in the visual field loss.

In FIG.s 19A and 19B, when a loss 202 exists at an upper part of the region of a visual field 201, as illustrated in FIG. 19A, a loss region 203 occurs in a visual field in which a driver can actually see. In the state illustrated in FIG. 19A, a traffic light 204 is visible, but when a vehicle moves closer to the traffic light 204, the traffic light 204 overlaps the loss region 203 and becomes invisible. In an actual case, the traffic light was green in the situation of FIG. 19A but became red in the situation of FIG. 19B, and as a result, the driver ignored the traffic light without braking.

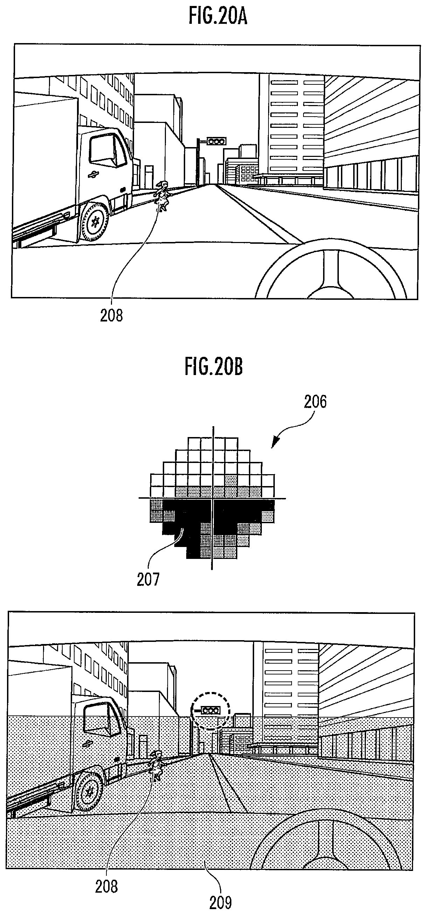

FIG.s 20A and 20B are explanatory diagrams of another exemplary visual field loss, FIG. 20A is an explanatory diagram of a state in which no visual field loss exists, and FIG. 20B is an explanatory diagram of a state in which a visual field loss exists at a lower part of a visual field. In FIG.s 20A and 20B, when a loss 207 exists at a lower part (lower half) of the region of a visual field 206, the driver cannot see a child 208 having jumped in as illustrated in FIG. 20A and overlapping a loss region 209 as illustrated in FIG. 20B. In an actual case, the driver ran over the child 208 having jumped in without braking. In particular, when the loss 207 exists at the lower part, a problem that a pedestrian cannot be seen with the line of sight pointing to a traffic light at the upper part is likely to occur.

As described above, it is thought that there is an accident scene likely to be caused by a visual field loss, but verification of a scene in which an actual accident occurred, such as examination of the existence of an accident history has not been performed in past reports.

Thus, when such influence of a visual field loss on driving, particularly, a causal relation with a traffic accident is studied with a drive simulator, it is needed to reproduce a visual field with a loss. A visual field with a loss can be reproduced by blacking out part of the visual field to simulate the state of the loss as in the technology disclosed in Patent Literature 1 or by using glasses (pin-hole glasses) with which the place of the loss is shielded.

However, the line of sight of a patient with a visual field loss moves and the visual field thereof moves as the patient moves the eyes even without moving the head, but when pin-hole glasses are used, the line of sight and the visual field do not move as long as the head is not moved. Thus, it is difficult to say that the situation of a visual field loss is reproduced by using pin-hole glasses.

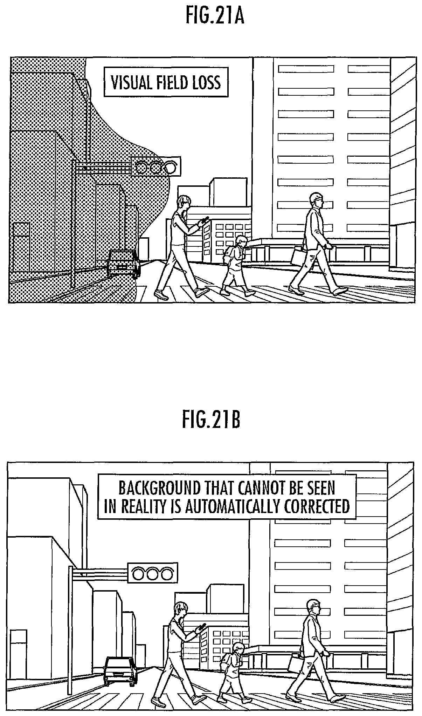

FIG.s 21A and 21B are explanatory diagrams of filling-in, FIG. 21A is an explanatory diagram of an image that can be seen when the filling-in function of a brain does not work, and FIG. 21B is an explanatory diagram of an image that can be seen when the filling-in function works in FIG. 21A.

In an actual visual field loss, the loss region thereof is invisible, but what is called a "filling-in" phenomenon in which the invisible region is automatically complemented by the brain as illustrated in FIG. 21B instead of being visible in black as illustrated in FIG. 21A occurs. The filling-in means a function, a process, or a phenomenon in which the brain of a human being automatically complements a part (blind spot or blind angle) that cannot be seen by one of the eyes with an image seen by the other eye. Thus, even when both eyes have parts with visual field losses, information is produced from surrounding scenery to achieve correction as if the parts are visible.

In the technology disclosed in Patent Literature 1, the filling-in is not considered, and an image that can be actually seen by a patient with a visual field loss is not an image in which part of scenery is blacked out by a mask image as disclosed in Patent Literature 1 but is an image or video in which an invisible part is complemented by the filling-in.

Thus, a patient with a visual field loss is not necessarily conscious of the visual field loss, and reality cannot be correctly reproduced by using the technology disclosed in Patent Literature 1 or pin-hole glasses. In known technologies of a drive simulator, control characteristics are changeable in accordance with settings as in the technologies disclosed in Patent Literatures 1 and 2, but no drive simulator with which a visual field loss with the filling-in taken into account can be reproduced or virtually experienced has been known.

The present invention is intended to solve the above-described problem and provide a driving simulator or the like with which a person with impaired vision can accurately recognize danger at driving or the like and influence of a visual field loss on driving can be experienced.

Solution to Problem

To achieve the above-described intention, an invention according to claim 1 of the present invention is a driving simulator with which vehicle driving is experienced in a simulated manner, and the driving simulator includes: an output interface; an operation unit operated by a user to drive a simulated vehicle; an operation state acquisition unit configured to acquire a state of operation of the operation unit by the user; a viewpoint acquisition unit configured to acquire a viewpoint of the user; a visual field loss information data storage unit configured to store visual field loss information data indicating a state of occurrence of a visual field loss of the user; a simulated video data storage unit configured to store simulated video data that visualizes a simulated travel environment; an association video data production unit configured to produce association video data in accordance with the state of operation of the operation unit by the user, the visual field loss information data, and the viewpoint of the user, the association video data being data in which the visual field loss information data and the simulated video data are associated with each other; and a video data display control unit configured to execute video data display control to display the association video data on the output interface.

With this driving simulator, the state of operation of the operation unit by the user is acquired, the association video data in accordance with the state of operation of the operation unit by the user, the visual field loss information data, and the viewpoint of the user, the association video data being data in which the visual field loss information data and the simulated video data are associated with each other is produced, and the video data display control to display the association video data on the output interface is executed ("acquisition" such as "operation state acquisition" or "viewpoint acquisition" in the present specification includes not only direct detection of an operation state or a viewpoint by a sensor or the like but also calculation of the value of the operation state or the viewpoint based on another parameter).

An invention according to claim 2 is the driving simulator according to claim 1 in which: the simulated video data includes a background part including a video of a fixed object, and a non-background part including a video of a moving object that moves in the background part; and the association video data production unit produces the association video data by, in accordance with the state of operation of the operation unit by the user, the visual field loss information data, and the viewpoint of the user, displaying an image of the background part overlapping a region in which the visual field loss occurs and changing an image of the non-background part overlapping the region in which the visual field loss occurs.

With this driving simulator, it is possible to provide a driving simulator with which influence of a visual field loss on driving can be experienced.

An invention according to claim 3 is the driving simulator according to claim 2 in which the visual field loss information data is configured as information on sensitivity distribution of visibility in a visual field centered at the viewpoint.

With this driving simulator, it is possible to reproduce the actual state of a visual field loss by using the sensitivity distribution information as visual field loss information unlike a case in which binary visual field loss information is used.

An invention according to claim 4 is the driving simulator according to claim 3 in which the association video data production unit changes transparency and contrast of the image of the non-background part in accordance with the sensitivity distribution.

With this driving simulator, a video closer to a situation that is seen in the actual state of visual field narrowing than a case in which the transparency is not changed in accordance with the sensitivity distribution can be displayed.

An invention according to claim 5 is the driving simulator according to claim 1 in which: the visual field loss information data is data in which the state of occurrence of the visual field loss of the user is associated with a visual field region of the user; the association video data production unit includes a simulated video display control unit configured to execute simulated video display control to display the simulated video data stored in the simulated video data storage unit on the output interface in accordance with the state of operation of the operation unit by the user, and a data production unit configured to produce the association video data as data in which the viewpoint of the user acquired by the viewpoint acquisition unit, the visual field loss information data, and a video of an object in the simulated video data are associated with one another being centered at the viewpoint of the user in an identical video during execution of the simulated video display control; the driving simulator further includes an association video data storage unit configured to store the association video data; and the video data display control unit executes, as the video data display control, video playback control to perform playback display of the association video data on the output interface after end of the simulated video display control.

With this driving simulator, during execution of the simulated video display control, the association video data is produced as data in which the viewpoint of the user acquired by the viewpoint acquisition unit, the visual field loss information data, and the video of an object in the simulated video data are associated with one another being centered at the viewpoint of the user in an identical video, and the association video data is stored in the association video data storage unit. Then, the video playback control to perform playback display of the association video data on the output interface is executed as the video data display control after end of the simulated video display control. In this case, the visual field loss information data is data in which the state of the visual field loss of the user is associated with the visual field region of the user, and thus when an object in the simulated video data overlaps a visual field region in which the visual field loss of the user occurs during execution of the simulated video display control, playback display of the overlapping state is performed during execution of the video playback control. Accordingly, the user can check the occurrence of a state in which the object in the simulated video data cannot be seen in reality since the object in the simulated video data overlaps the visual field region in which the visual field loss of the user occurs. As a result, the user with impaired vision due to the visual field loss can accurately understand danger when the user drives.

An invention according to claim 6 is the driving simulator according to claim 5 further including: a dangerous state determination unit configured to determine whether a simulated dangerous state of at least one of contact and precontact of the simulated vehicle with another object in the simulated travel environment has occurred during execution of the simulated video display control; and a dangerous state display unit configured to display a result of the occurrence determination of the simulated dangerous state by the dangerous state determination unit on the output interface during execution or after end of the video playback control.

With this driving simulator, whether the simulated dangerous state of at least one of contact and precontact of the simulated vehicle with another object in the simulated travel environment has occurred is determined during execution of the simulated video display control, and the result of the occurrence determination of the simulated dangerous state is displayed on the output interface during execution or after end of the video playback control. Accordingly, the user with impaired vision can accurately understand the occurrence of a dangerous state when the user drives a vehicle.

An invention according to claim 7 is the driving simulator according to claim 5 or 6 further including: an overlapping situation parameter acquisition unit configured to acquire an overlapping situation parameter indicating a state of occurrence of an overlapping situation in which an object in the simulated video data overlaps the region in which the visual field loss in the visual field loss information data occurs during execution of the simulated video display control; a correlation model storage unit configured to store a correlation model indicating a correlation between the overlapping situation parameter and a danger degree indicating a probability that the simulated dangerous state of at least one of contact and precontact of the simulated vehicle with another object in the simulated travel environment occurs; a driving danger degree determination unit configured to determine the danger degree of the user at vehicle driving by using the correlation model and the overlapping situation parameter of the user; and a driving danger degree display unit configured to display a result of the determination of the danger degree at vehicle driving by the driving danger degree determination unit on the output interface during execution or after end of the video playback control.

With this driving simulator, the overlapping situation parameter is acquired during execution of the simulated video display control, and the danger degree of the user at vehicle driving is determined by using the correlation model and the overlapping situation parameter of the user. The overlapping situation parameter indicates the state of occurrence of an overlapping situation in which an object in the simulated video data overlaps the region in which the visual field loss in the visual field loss information data occurs. The correlation model indicates the correlation between the overlapping situation parameter and the danger degree indicating the probability that the dangerous state of at least one of contact and precontact of the simulated vehicle with another object in the simulated travel environment occurs. Thus, the danger degree of the user at vehicle driving can be accurately determined by using the correlation model and the overlapping situation parameter of the user as described above. In addition, since the result of the determination of the danger degree at vehicle driving by the driving danger degree determination unit is displayed on the output interface during execution or after end of the video playback control, the user with impaired vision can accurately understand the danger degree of the user at vehicle driving.

To achieve the above-described intention, a video control device according to claim 8 of the present invention includes: an output interface; a visual field loss information data storage unit configured to store visual field loss information data in which a state of occurrence of a visual field loss of a user is associated with a visual field region of the user; a moving image video data storage unit configured to store a moving image video data including an object; a moving image display control unit configured to execute moving image display control to display the moving image video data stored in the moving image video data storage unit on the output interface; a viewpoint acquisition unit configured to acquire a viewpoint of the user during execution of the moving image display control; an association video data storage unit configured to store, as the association video data, data in which the viewpoint of the user, the visual field loss information data, and a video of the object in the moving image video data are associated with one another being centered at the viewpoint of the user in an identical video during execution of the moving image display control; and a video playback control unit configured to execute video playback control to perform playback display of the association video data on the output interface after end of the moving image display control.

With this video control device, the moving image display control to display the moving image video data stored in the moving image video data storage unit on the output interface is executed. The viewpoint of the user is acquired during execution of the moving image display control, and the data in which the viewpoint of the user, the visual field loss information data, and the video of the object in the moving image video data are associated with one another being centered at the viewpoint of the user in an identical video is stored as the association video data. Then, the video playback control to perform playback display of the association video data on the output interface is executed after end of the moving image display control. In this case, the visual field loss information data is data in which the state of the visual field loss of the user is associated with the visual field region of the user, and thus when the object in the moving image video data overlaps the visual field region in which the visual field loss of the user occurs during execution of the moving image display control, playback display of the overlapping state is performed during execution of the video playback control. Accordingly, the user can check the occurrence of a state in which the object in the moving image video data overlaps the visual field region in which the visual field loss of the user occurs, in other words, a state in which the object in the moving image video data cannot be seen in reality. As a result, the user with impaired vision due to the visual field loss can accurately understand danger, for example, when the user walks.

Brief Description of Drawings

FIG. 1 is a diagram illustrating the configuration of a driving simulator according to an embodiment of the present invention.

FIG. 2 is a block diagram illustrating an electric configuration of the driving simulator.

FIG. 3 is a diagram illustrating exemplary visual field loss information data of a user.

FIG. 4 is a flowchart illustrating simulated travel control.

FIG. 5 is a diagram illustrating an exemplary moving image video during simulated video display control.

FIG. 6 is a flowchart illustrating playback display control.

FIG. 7 is a diagram illustrating exemplary visual field video data.

FIG. 8 is a diagram illustrating exemplary visual field video data when time has elapsed since the state of FIG. 7.

FIG. 9 is a diagram illustrating other exemplary visual field video data.

FIG. 10 is a diagram illustrating exemplary visual field video data when time has elapsed since the state of FIG. 9.

FIG. 11 is a diagram illustrating an exemplary map used for danger degree determination.

FIG. 12 is a diagram illustrating exemplary display of the number of danger occurrences.

FIG. 13 is a diagram illustrating exemplary display of a driving danger degree.

FIG. 14 is a block diagram illustrating functions of a driving simulator of a second embodiment.

FIG. 15A is an explanatory diagram of an exemplary video displayed at the driving simulator and is an explanatory diagram of the video without visual field narrowing.

FIG. 15B is an explanatory diagram of the video in which the line of sight is positioned at the center and the left half of the visual field is lost.

FIG. 15C is an explanatory diagram of the video in which the line of sight has moved to the left side as compared to FIG. 15B.

FIG. 16A is an explanatory diagram of another exemplary video displayed at the driving simulator and is an explanatory diagram of the video without visual field narrowing.

FIG. 16B is an explanatory diagram of the video in which the line of sight is positioned at the center and a loss occurs except at a central part of the visual field.

FIG. 16C is an explanatory diagram of the video in which the line of sight has moved to the right side as compared to FIG. 16B.

FIG. 17 is an explanatory diagram of exemplary information of the visual field.

FIG. 18 is an explanatory diagram of a flowchart of visual field narrowing video display processing of the second embodiment.

FIG. 19A is an explanatory diagram of an exemplary visual field loss and is an explanatory diagram of a state in which a traffic light is not included in the visual field loss.

FIG. 19B is an explanatory diagram of an exemplary visual field loss and is an explanatory diagram of a state in which the traffic light is included in the visual field loss.

FIG. 20A is an explanatory diagram of another exemplary visual field loss and is an explanatory diagram of a state in which no visual field loss exists.

FIG. 20B is an explanatory diagram of another exemplary visual field loss and is an explanatory diagram of a state in which a visual field loss exists at a lower part of a visual field.

FIG. 21A is an explanatory diagram of an image that can be seen when the filling-in function of a brain does not work.

FIG. 21B is an explanatory diagram of an image that can be seen when the filling-in function works in FIG. 21A.

Description of Embodiments

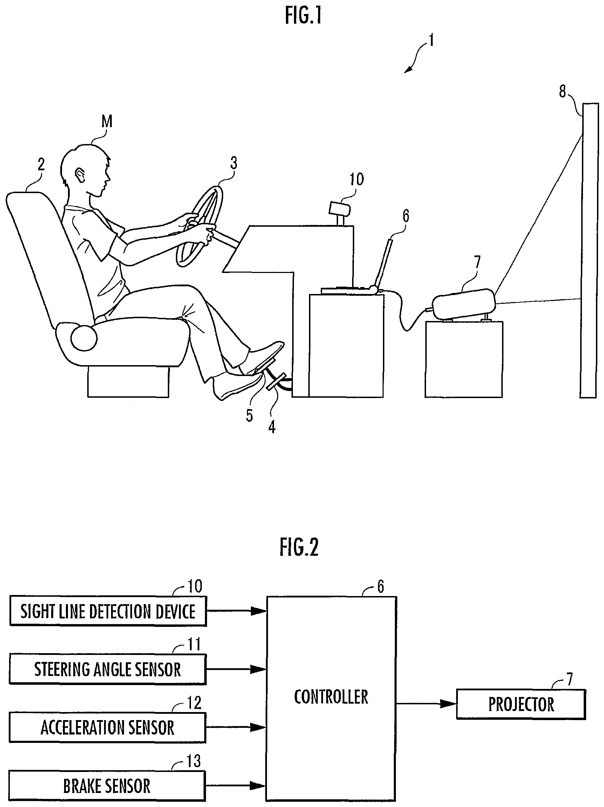

A driving simulator according to a first embodiment of the present invention will be described below with reference to the accompanying drawings. As illustrated in FIG. 1, a driving simulator 1 of the present embodiment is of a four-wheel vehicle type in which a user M sits on a driving sheet 2 and performs simulated driving, and includes the driving sheet 2, a steering wheel 3, an acceleration pedal 4, and a brake pedal 5 as parts of a simulated vehicle.

The steering wheel 3 is operated by the user M to change the traveling path of the simulated vehicle in simulated driving. The steering wheel 3 includes a steering angle sensor 11 (refer to FIG. 2), and the steering angle sensor 11 detects the angle of steering of the steering wheel 3 by the user M in simulated driving and outputs a detection signal indicating the detected angle to a controller 6.

The acceleration pedal 4 is operated by the user M to, for example, accelerate the simulated vehicle in simulated driving. The acceleration pedal 4 includes an acceleration sensor 12 (refer to FIG. 2), and the acceleration sensor 12 detects the amount of step-in of the acceleration pedal 4 by the user M and outputs a detection signal indicating the detected amount to the controller 6.

The brake pedal 5 is operated by the user M to brake the simulated vehicle in simulated driving. The brake pedal 5 includes a brake sensor 13 (refer to FIG. 2), and the brake sensor 13 detects the amount of step-in of the brake pedal 5 by the user M and outputs a detection signal indicating the detected amount to the controller 6.

In the present embodiment, the steering wheel 3, the acceleration pedal 4, and the brake pedal 5 correspond to an operation unit, and the steering angle sensor 11, the acceleration sensor 12, and the brake sensor 13 correspond to an operation state acquisition unit.

The driving simulator 1 further includes the controller 6, a projector 7, a screen 8, and a sight line detection device 10. The sight line detection device 10 (viewpoint acquisition unit) detects the line of sight of the user M based on motion of the eyeballs of the user M and outputs a detection signal indicating the detected line of sight to the controller 6. The controller 6 determines a viewpoint O of the user M based on the detection signal from the sight line detection device 10. In the following description, the sight line detection device 10 and the above-described three sensors 11 to 13 are collectively referred to as "various sensor 10 to 13".

The controller 6 is of a laptop personal computer type and includes a storage, a memory, and a keyboard (all not illustrated). Computer programs, video data, acoustic data, and the like for simulated driving control are stored in the storage and memory of the controller 6.

Before execution start of simulated driving control to be described later, visual field loss information data of the user M is input to the controller 6 from outside and stored in the memory. The visual field loss information data indicates the state of occurrence of a visual field loss of the user M for each visual field region of the user M and is produced based on a result of examination at a medical institution or the like. Thus, the visual field loss information data input to the controller 6 when simulated driving is to be executed is different for each user.

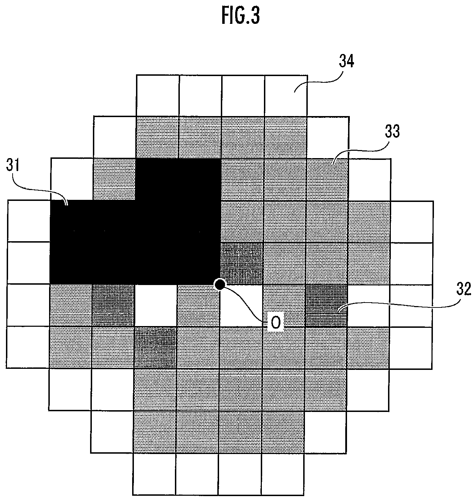

The visual field loss information data is configured, for example, as illustrated in FIG. 3. In the visual field loss information data illustrated in the drawing, 76 visual field regions of 19 upper-left visual field regions, 19 lower-left visual field regions, 19 upper-right visual field regions, and 19 lower-right visual field regions are set being centered at the viewpoint (gaze point) O of the user M. These visual field regions are classified into sensitivity regions at four levels of a non-sensitivity region 31, a low sensitivity region 32, an intermediate sensitivity region 33, and a high sensitivity region 34.

The non-sensitivity region 31 is a region illustrated in black in the drawing and corresponds to a region in which the retina of the user M has almost no sensitivity. The high sensitivity region 34 is a region illustrated in white in the drawing and corresponds to a region in which the retina of the user M has normal sensitivity. The low sensitivity region 32 and the intermediate sensitivity region 33 are regions illustrated both in gray shading. The low sensitivity region 32 has sensitivity between the non-sensitivity region 31 and the intermediate sensitivity region 33 and is illustrated in gray shading darker than that of the intermediate sensitivity region 33. The intermediate sensitivity region 33 has sensitivity between the low sensitivity region 32 and the high sensitivity region 34. The total number of visual field regions and the number of levels of sensitivity regions are not limited to those described above but may be each increased or decreased.

The controller 6 executes the simulated driving control to be described later or the like when an input unit such as a keyboard is operated by an operator. During execution of the simulated driving control, the controller 6 outputs an image signal and a voice signal to the projector 7 and a speaker (not illustrated) based on the detection signals from the various sensors 10 to 13 described above. Accordingly, the operation states of the projector 7 and the speaker are controlled.

In addition, during execution of the simulated driving control, the controller 6 produces visual field video data (refer to FIG.s 7 to 10) as moving image video data by placing the above-described visual field loss information data over a video of a traffic participant, a traffic light, or the like in a simulated video and stores the data in the memory.

In the present embodiment, the controller 6 corresponds to a visual field loss information data storage unit, a simulated video data storage unit, an association video data production unit, a video data display control unit, a data production unit, an association video data storage unit, a dangerous state determination unit, a dangerous state display unit, an overlapping situation parameter acquisition unit, a correlation model storage unit, a driving danger degree determination unit, and a driving danger degree display unit.

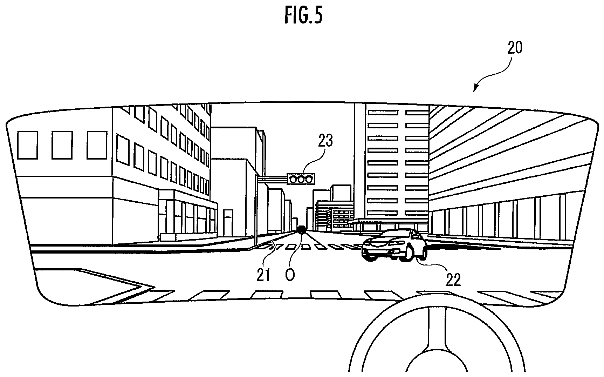

When the image signal is input from the controller 6 during execution of the simulated driving control described above, the projector 7 displays a simulated travel video on the screen 8 in accordance with the image signal (refer to FIG. 5). As described later, when playback control is executed after execution of the simulated driving control, the projector 7 displays the visual field video data stored in the controller 6 during the simulated driving control described above on the screen 8 (refer to FIG.s 7 to 10). In the present embodiment, the projector 7 and the screen 8 correspond to an output interface.

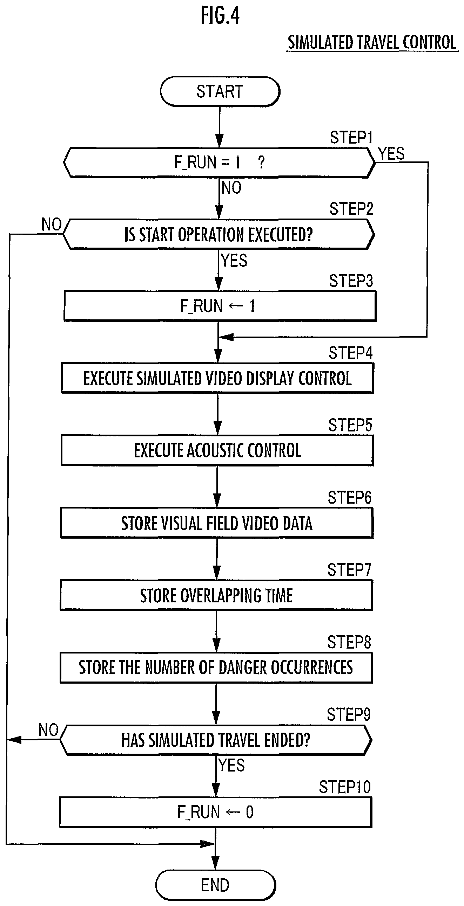

Subsequently, simulated travel control will be described below with reference to FIG. 4. The simulated travel control is control of the state of simulated traveling by the user M and is executed in a predetermined control period by the controller 6.

First, it is determined whether a simulated travel flag F_RUN is "1" (STEP1 in FIG. 4). When the determination is negative (NO at STEP1 in FIG. 4), it is determined whether operation to start the simulated travel control is executed (STEP2 in FIG. 4). In this case, the operation to start the simulated travel control is executed through an operation of the input unit of the controller 6 by the operator.

When the determination is negative (NO at STEP2 in FIG. 4), the present processing is directly ended. When the determination is positive (YES at STEP2 in FIG. 4), the simulated travel flag F RUN is set to "1" to indicate that the simulated travel control is to be executed (STEP3 in FIG. 4).

When the simulated travel flag F RUN is set to "1" in this manner or when the above-described determination is positive (YES at STEP1 in FIG. 4) and the simulated travel flag F RUN is set to "1" at the previous or earlier control timing, simulated video display control is executed (STEP4 in FIG. 4).

In the simulated video display control, for example, a moving image video 20 as illustrated in FIG. 5 is displayed on the screen 8 by the projector 7 based on the above-described detection signals from the various sensors 10 to 13 and simulated driving control video data in the controller 6. The moving image video 20 displays a travel environment on the front side of the simulated vehicle, and specifically, a travel line 21 of the simulated vehicle, a traffic participant (another vehicle 22 or a pedestrian (not illustrated)), a traffic light 23, and the like are displayed being centered at the viewpoint O of the user M.

Subsequently, acoustic control is executed (STEP5 in FIG. 4). In the acoustic control, an acoustic signal is supplied to the speaker based on the above-described simulated driving control acoustic data. Accordingly, for example, travel sound, engine sound, and brake sound of the simulated vehicle are output from the speaker.

Then, the visual field video data is stored in the memory of the controller 6 (STEP6 in FIG. 4). As described above, the visual field video data is moving image video data and is, for example, data in which image data of a traffic participant (for example, another vehicle 24) and the traffic light 23 in the moving image video 20 is placed over the visual field loss information data, being centered at the viewpoint O of the user M as illustrated in FIG.s 7 to 10.

Thereafter, overlapping times are stored (STEP7 in FIG. 4). In this case, first to third overlapping times t1 to t3 are stored as the overlapping times. The first overlapping time t1 is a cumulated value of the occurrence duration of overlapping between an object such as a traffic participant, a traffic light, or the like and the non-sensitivity region 31 in the visual field loss information data when the object is positioned in the region during execution of the simulated travel control.

The second overlapping time t2 is a cumulated value of the occurrence duration of overlapping between an object such as a traffic participant, a traffic light, or the like and the low sensitivity region 32 in the visual field loss information data when the object is positioned in the region during execution of the simulated travel control. The third overlapping time t3 is a cumulated value of the occurrence duration of overlapping between an object such as a traffic participant, a traffic light, or the like and the intermediate sensitivity region 33 in the visual field loss information data when the object is positioned in the region during execution of the simulated travel control.

Subsequently, the number of danger occurrences is stored (STEP8 in FIG. 4). This storage processing of the number of danger occurrences is executed as described below. First, it is determined whether an accidental contact in which the simulated vehicle contacts a traffic participant or an obstacle has occurred during execution of the simulated travel control and whether a near-miss state such as a dangerous state in which the simulated vehicle almost contacts a traffic participant or an obstacle or a state in which a traffic light is ignored has occurred. When an accidental contact has occurred, the number of occurrences thereof is accumulated to calculate the number of accident occurrences. When the near-miss state has occurred, the number of occurrences thereof is accumulated to calculate the number of near-misses. Thereafter, the number of accident occurrences and the number of near-misses are stored in the memory of the controller 6 as the number of danger occurrences.

Then, it is determined whether simulated travel has ended (STEP9 in FIG. 4). In this case, it is determined that the simulated travel has ended when playback display of the simulated driving control video data is performed to the last or when an operation to stop the simulated travel is executed through an operation of the input unit of the controller 6 by the operator for some reason during execution of the simulated travel.

When the determination is negative (NO at STEP9 in FIG. 4), the present processing is directly ended. When the determination is positive (YES at STEP9 in FIG. 4), the simulated travel flag F_RUN is set to "0" to indicate that the simulated travel control is to be ended (STEP 10 in FIG. 4). Thereafter, the present processing is ended.

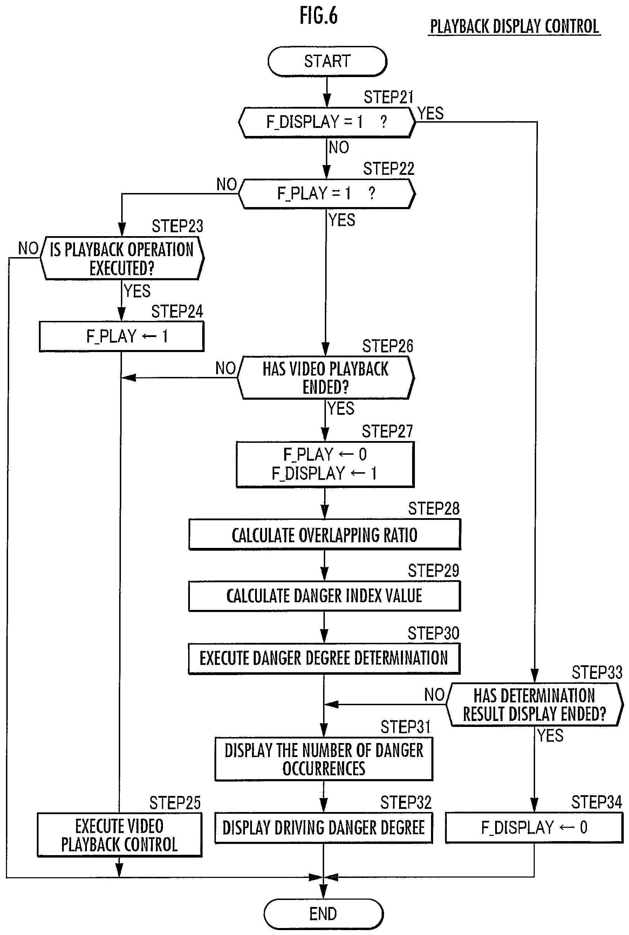

Subsequently, playback display control will be described below with reference to FIG. 6. The playback display control performs playback display of the above-described visual field video data and displays the number of danger occurrences during simulated travel and the like, and is executed in a predetermined control period by the controller 6 after execution of the simulated travel control.

As illustrated in the drawing, first, it is determined whether a determination result display flag F_DISPLAY is " 1" (STEP21 in FIG. 6). When the determination is negative (NO at STEP21 in FIG. 6), it is determined whether a playback control execution flag F_PLAY is "1" (STEP22 in FIG. 6).

When the determination is negative (NO at STEP22 in FIG. 6), it is determined whether playback operation is executed through an operation of the input unit of the controller 6 by the operator (STEP23 in FIG. 6). When the determination is negative (NO at STEP23 in FIG. 6), the present processing is directly ended.

When the determination is positive (YES at STEP23 in FIG. 6), in other words, when the playback operation is executed, the playback control execution flag F_PLAY is set to "1" to indicate the execution (STEP24 in FIG. 6).

Then, video playback control is executed (STEP25 in FIG. 6). In the video playback control, playback display of the visual field video data stored in the memory of the controller 6 during execution of the simulated travel control is performed on the screen 8, for example, as illustrated in FIG.s 7 to 10. In this case, the playback display of the visual field video data is performed by a method such as continuous playback or frame-by-frame playback of still images.

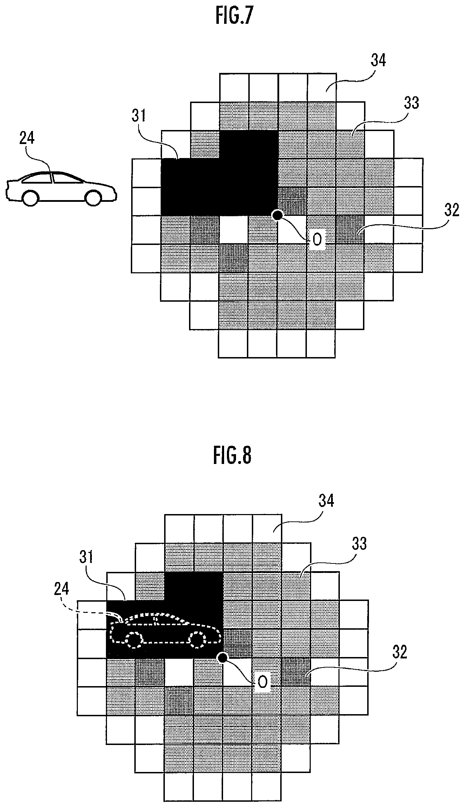

FIG. 7 illustrates a state before an image of the other vehicle 24 enters the visual field regions of the user M, and FIG. 8 illustrates a state in which the image of the other vehicle 24 in the state illustrated in FIG. 7 has entered the non-sensitivity region 31 in the visual field regions of the user M as time elapses. In other words, FIG. 8 illustrates a state in which the image of the other vehicle 24 and the non-sensitivity region 31 overlap each other. In FIG. 8, the other vehicle 24 in the non-sensitivity region 31 is illustrated with a while dashed line to facilitate understanding, but the other vehicle 24 in the non-sensitivity region 31 is not displayed in the actual visual field video data.

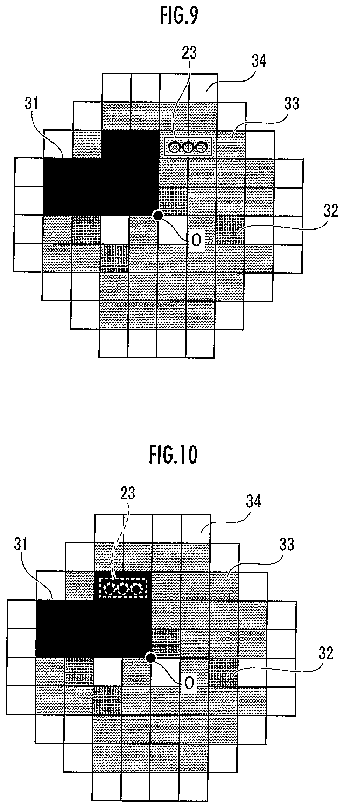

FIG. 9 illustrates a state in which an image of the traffic light 23 is in the intermediate sensitivity region 33, and FIG. 10 illustrates a state in which the image of the traffic light 23 in the state illustrated in FIG. 9 has entered the non-sensitivity region 31 in the visual field regions of the user M as time elapses. In other words, FIG. 10 illustrates a state in which the image of the other vehicle 24 and the non-sensitivity region 31 overlap each other. In FIG. 10, the traffic light 23 in the non-sensitivity region 31 is illustrated with a while dashed line to facilitate understanding, but the traffic light 23 in the non-sensitivity region 31 is not displayed in the actual visual field video data. In FIG.s 7 to 10 described above, any scenery image other than the other vehicle 24 and the traffic light 23 is omitted to facilitate understanding.

As illustrated in FIG.s 8 and 10, when the other vehicle 24 and the image of the traffic light 23 overlap the non-sensitivity region 31 of the user M, the user M can understand and recognize the occurrence of a state in simulated driving, in which the other vehicle 24 and the traffic light 23 are not visually recognized in reality. After the video playback control is executed as described above, the present processing is ended.

When the above-described determination is positive (YES at STEP22 in FIG. 6) and the playback control execution flag F_PLAY is "1", it is determined whether video playback of the visual field video data has ended (STEP26 in FIG. 6). In this case, when playback display of the visual field video data has been performed to the last, it is determined that simulated travel is ended.

When the determination is negative (NO at STEP26 in FIG. 6), the video playback control is executed as described above (STEP25 in FIG. 6). Thereafter, the present processing is ended.

When the determination is positive (YES at STEP26 in FIG. 6) and video playback of the visual field video data has ended, the playback control execution flag F_PLAY is set to "0" to indicate the positive determination and the ending. Simultaneously, the determination result display flag F_DISPLAY is set to "1" to indicate that the number of danger occurrences and the like are to be displayed (STEP27 in FIG. 6).

Then, overlapping ratios are calculated (STEP28 in FIG. 6). In this case, the three values of first to third ratios are calculated as the overlapping ratios. The first ratio is a ratio at which another vehicle, a traffic light, or the like overlaps the non-sensitivity region 31 during execution of the simulated travel control, and specifically, is calculated as a percentage $(t1/t\_all) \times 100$ for a total execution time t_all of the simulated travel control in the above-described first overlapping time t1.

The second ratio is a ratio at which another vehicle, a traffic light, or the like overlaps the low sensitivity region 32 during execution of the simulated travel control, and specifically, is calculated as a percentage $(t2/t\_all) \times 100$ for a total execution time t_all of the simulated travel control in the above-described second overlapping time t2. The third ratio is a ratio at which another vehicle, a traffic light, or the like overlaps the intermediate sensitivity region 33 during execution of the simulated travel control, and specifically, is calculated as a percentage $(t3/t\_all) \times 100$ for a total execution time t_all of the simulated travel control in the above-described third overlapping time t3.

Then, a danger index value Xref is calculated by Expression (1) below (STEP29 in FIG. 6).
[Expression 1]

$$Xref = m1 \cdot \frac{t1}{t\_all} + m2 \cdot \frac{t2}{t\_all} + m3 \cdot \frac{t3}{t\_all} \qquad \cdots(1)$$

In Expression (1), m1 to m3 are weight coefficients set so that $1 \geq m1 > m2 > m3 > 0$ hold. As indicated in Expression (1) above, the danger index value Xref is calculated as a value obtained by weighting degrees at which another vehicle, a traffic light, or the like overlaps the non-sensitivity region 31, the low sensitivity region 32, and the intermediate sensitivity region 33 during execution of the simulated travel control. In other words, the danger index value Xref is calculated as an overlapping situation parameter indicating the state of occurrence of an overlapping situation. The above-described weight coefficients m1 to m3 are set based on, for example, a statistical result when the simulated travel control is executed as described above for a large number of users each having a visual field loss and the actual accident histories of the users.

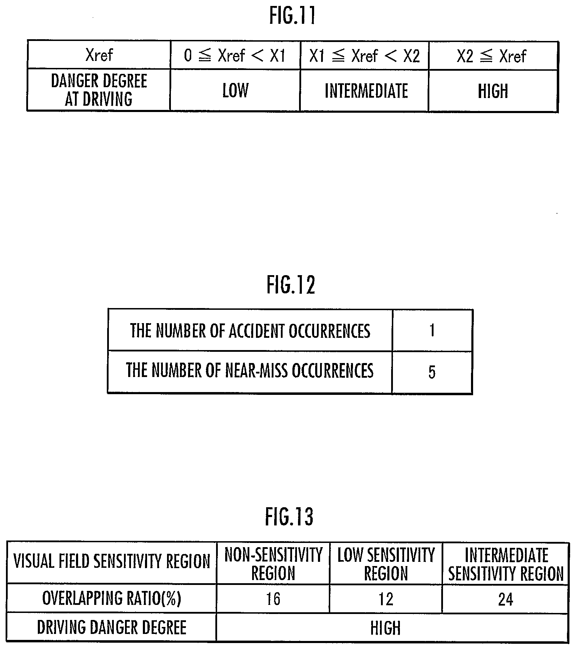

Subsequently, danger degree determination is executed (STEP30 in FIG. 6). Specifically, it is determined whether a danger degree (hereinafter referred to as a "driving danger degree") of the user M at driving is in the region of "low", "intermediate", or "high" by searching a map illustrated in FIG. 11 in accordance with the danger index value Xref calculated as described above. The danger degree indicates the magnitude of a probability that the user in simulated driving causes at least one of an accidental contact and a near-miss.

In the drawing, X1 and X2 are predetermined threshold values set so that X1 < X2 holds, and these predetermined threshold values X1 and X2 are set based on, for example, a statistical result when the simulated travel control is executed as described above for a large number of users each having a visual field loss and the actual accident histories of the users.

Thereafter, the number of danger occurrences is displayed (STEP31 in FIG. 6). Specifically, the number of accident occurrences of the user M and the number of near-miss occurrences thereof in the simulated travel control are displayed on the screen 8 in a state illustrated in FIG. 12. In this case, one of the number of accident occurrences and the number of near-miss occurrences may be displayed.

Then, the driving danger degree is displayed (STEP32 in FIG. 6). Specifically, calculation results of the above-described overlapping ratios of the non-sensitivity region 31, the low sensitivity region 32, and the intermediate sensitivity region 33 and a result of the determination of the driving danger degree in the simulated travel control of the user M are displayed on the screen 8 in a state illustrated in FIG. 13. Thereafter, the present processing is ended.

When the above-described determination is positive (YES at STEP21 in FIG. 6) and the determination result display flag F_DISPLAY is "1", in other words, when the number of danger occurrences and the driving danger degree are displayed at the previous or earlier control timing, it is determined whether display of the determination result has ended (STEP33 in FIG. 6). Specifically, when operation to end display of the determination result is executed through an operation of the input unit of the controller 6 by the operator, it is determined that display of the determination result has ended.

When the determination is negative (NO at STEP33 in FIG. 6), the number of danger occurrences and the driving danger degree are displayed as described above, and then the present processing is ended.

When the determination is positive (YES at STEP33 in FIG. 6), the determination result display flag F_DISPLAY is set to "0" to indicate that display of the determination result is ended (STEP34 in FIG. 6). Thereafter, the present processing is ended.

As described above, with the driving simulator 1 of the present embodiment, the simulated travel control is executed after the visual field loss information data (FIG. 3) in which the state of a visual field loss of the user M is associated with the visual field regions of the user M is input to the controller 6. During execution of the simulated travel control, the viewpoint O of the user M is detected by the sight line detection device 10, and data in which the viewpoint O of the user M, the visual field loss information data, a video of an object in simulated video data are associated with one another being centered at the viewpoint O of the user M in an identical video is produced as association video data (FIG.s 7 to 10) and stored in the memory of the controller 6.

Then, the video playback control is executed after end of the simulated travel control. In the video playback control, playback display of the association video data is performed on the screen 8. As described above, the association video data is data in which the visual field loss information data, the viewpoint O of the user M, and a video of the other vehicle 24, the traffic light 23, or the like in the simulated video data are associated with one another being centered at the viewpoint O of the user M in an identical video. Thus, the user M can check the occurrence of a state in which the other vehicle 24, the traffic light 23, or the like in the simulated video data overlaps the visual field region in which the visual field loss of the user occurs, in other words, a state in which the other vehicle 24, the traffic light 23, or the like in the simulated video data cannot be seen in reality. As a result, the user having a visual field loss, in other words, the user M with impaired vision can accurately recognize danger when the user drives.

It is determined whether accidental contact or a near-miss state of the simulated vehicle with another object in a simulated travel environment has occurred during execution of the simulated travel control, and playback display of the number of occurrences is performed on the screen 8 after end of the video playback control (FIG. 12). Accordingly, the user M with impaired vision can accurately recognize the occurrence of a dangerous state when the user drives a vehicle.

In addition, during execution of the simulated travel control, the danger index value Xref is calculated and the danger degree of the user M at vehicle driving is determined by using the danger index value Xref and the map (FIG. 11). Since the danger index value Xref is calculated as a value obtained by weighting the degrees at which another vehicle, a traffic light, or the like overlaps the non-sensitivity region 31, the low sensitivity region 32, and the intermediate sensitivity region 33, the danger index value Xref indicates the state of occurrence of an overlapping situation in which another vehicle, a traffic light, or the like in the simulated video data overlaps the non-sensitivity region 31, the low sensitivity region 32, and the intermediate sensitivity region 33 in the visual field loss information data. The map is produced to appropriately express the correlation between the danger index value Xref and the danger degree at driving. Thus, the danger degree of the user M with impaired vision at vehicle driving can be accurately determined by using the danger index value Xref and the map.

In addition, after end of the video playback control, the overlapping ratios at which another vehicle, a traffic light, or the like overlaps the non-sensitivity region 31, the low sensitivity region 32, and the intermediate sensitivity region 33 and the driving danger degree are displayed on the screen 8 as illustrated in FIG. 13, and thus the user M with impaired vision can accurately recognize the danger degree of the user at vehicle driving.

The first embodiment is an example in which a vehicle of a four-wheel vehicle type is used as the simulated vehicle, but various simulated vehicles may be used instead. For example, a two-wheel vehicle, a three-wheel vehicle, or a vehicle of six or more wheels may be used as the simulated vehicle.

The first embodiment is also an example in which the projector 7 and the screen 8 are used as the output interface, but the output interface of the present invention is not limited thereto and may be any device capable of displaying the simulated video data and the association video data. For example, a liquid crystal display, an organic EL display, a 3D hologram device, or a head-mounted display may be used as the output interface.

The first embodiment is also an example in which the steering wheel 3, the acceleration pedal 4, and the brake pedal 5 are used as the operation unit, but the operation unit of the present invention is not limited thereto and may be any unit operated by the user to drive the simulated vehicle. For example, when the simulated vehicle is of a two-wheel vehicle type, a slot lever, a brake lever, and the like correspond to the operation unit.

The first embodiment is also an example in which the sensors 11 to 13 are used as the operation state acquisition unit, but the operation state acquisition unit of the present invention is not limited thereto and may be any device configured to acquire the state of operation of the operation unit by the user. For example, when the operation unit is the slot lever and the brake lever of a two-wheel vehicle, sensors configured to detect their operation amounts may be used.

The first embodiment is also an example in which the sight line detection device 10 is used as the viewpoint acquisition unit, but the viewpoint acquisition unit of the present invention is not limited thereto and may be any device capable of detecting the viewpoint of the user.

The first embodiment is also an example in which the controller 6 of a laptop personal computer type is used as a simulated video display control unit and a video playback control unit, but the simulated video display control unit and the video playback control unit of the present invention are not limited thereto and may be any devices configured to execute the simulated video display control and the video playback control. For example, a desktop personal computer and a control circuit may be used as the simulated video display control unit and the video playback control unit, or a personal computer and a server may be used in combination.

The first embodiment is also an example in which the danger index value Xref is used as the overlapping situation parameter, but the overlapping situation parameter of the present invention is not limited thereto and may be any value that indicates the state of occurrence of an overlapping situation in which an object in the simulated video data overlaps the occurrence region of a visual field loss in the visual field loss information data. For example, only the first term $(m1 \cdot t1/t\_all)$ on the right hand side of Expression (1), the value $t1/t\_all$, the sum $(m1.t1/t\_all) + (m2 \cdot t2/t\_all)$ of the first and second terms on the right hand side, or the three ratios $t1/t\_all$, $t2/t$ all, $t3/t$ all may be used as the overlapping situation parameter. Alternatively, the first to third overlapping times t1 to t3 may be used as the overlapping situation parameter.

The first embodiment is also an example in which the map of FIG. 11 is used as the correlation model, but the correlation model of the present invention is not limited thereto and may be any map that indicates of the correlation between the overlapping situation parameter and the danger degree. For example, a line map in which the correlation between the overlapping situation parameter and the danger degree is expressed on orthogonal coordinate axes may be used as the correlation model.

The first embodiment is also an example in which the number of accident occurrences and the number of near-miss occurrences (FIG. 12) are displayed after end of the video playback control, but the numbers may be displayed during execution of the video playback control. In this case, the number of accident occurrences and the number of near-miss occurrences may be incremented at each occurrence, and the total numbers of occurrences may be displayed from the start.

The first embodiment is also an example in which the driving danger degree and the overlapping ratios (FIG. 13) are displayed after end of the video playback control, but the degrees and the ratios may be displayed during execution of the video playback control. In this case, the driving danger degree and the overlapping ratios may be calculated again at each occurrence of an overlapping state.

A video control device of the present invention may be configured by omitting the components 3 to 5 and the sensors 11 to 13 related to the simulated vehicle in the above-described driving simulator 1 of the first embodiment. In this case, the projector 7 and the screen 8 correspond to the output interface, and the sight line detection device 10 corresponds to the viewpoint acquisition unit. In addition, the controller 6 corresponds to the visual field loss information data storage unit, a moving image video data storage unit, a moving image display control unit, the association video data storage unit, and the video playback control unit.

In this video control device, moving image data such as a normal scenery video is stored in the memory of the controller 6 in place of the above-described simulated driving control video data. After the above-described visual field loss information data of the user is stored in the memory, moving image display control is executed in place of the above-described simulated travel control in FIG. 6.

In the moving image display control, the moving image data in the memory of the controller 6 is displayed on the screen 8 through the projector 7. Then, during execution of the moving image display control, the viewpoint of the user is acquired from the above-described detection signals from the sight line detection device 10, and the visual field video data is stored in the memory of the controller 6 as in the above-described STEP6 in FIG. 4. The visual field video data is data in which image data of an object in a moving image video is placed over the visual field loss information data (for example, FIG. 3), being centered at the viewpoint O of the user.

After the moving image display control is executed in this manner, the video playback control is executed similarly to the above-described video playback control (STEP25 in FIG. 6). Accordingly, similarly to the above-described FIG.s 7 to 10, the user can check a state in which an object in a scenery video overlaps, for example, the non-sensitivity region 31, the low sensitivity region 32, and the intermediate sensitivity region 33 in the visual field region of the user. As a result, the user with impaired vision can accurately recognize danger, for example, when the user walks.

Subsequently, a driving simulator of a second embodiment of the present invention will be described below. The driving simulator 1 of the present embodiment is identical to the driving simulator 1 of the first embodiment in mechanical and electric configurations but is different only in the contents of control processing, and thus only the difference will be mainly described below. Any component identical to that of the first embodiment is denoted by the same reference sign, and description thereof is omitted.

(Description of control unit of second embodiment)

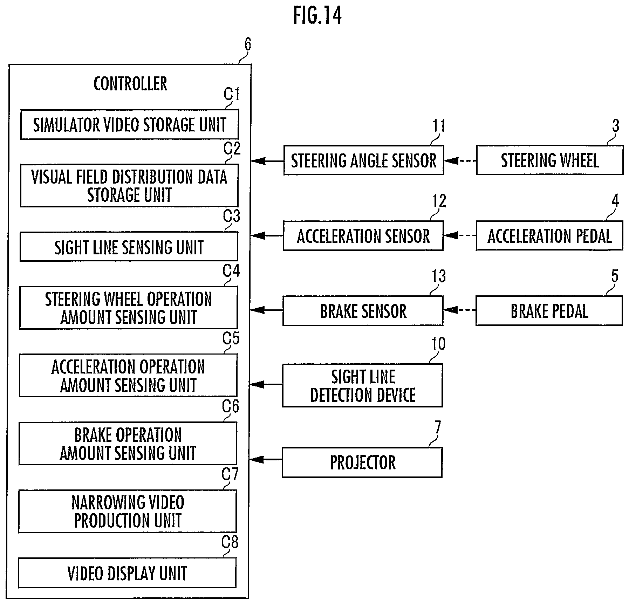

FIG. 14 is a block diagram illustrating functions of the driving simulator 1 of the second embodiment. In FIG. 14, the controller 6 of the driving simulator 1 includes an input-output interface I/O configured to perform inputting and outputting of signals to and from outside and the like.

(Signal output elements connected with controller 6 of driving simulator 1)

The controller 6 of the driving simulator 1 receives output signals from the steering angle sensor 11, the acceleration sensor 12, the brake sensor 13, the sight line detection device 10, and any other signal output element such as a sensor (not illustrated).

In the present embodiment, the controller 6 corresponds to the visual field loss information data storage unit, the simulated video data storage unit, the association video data production unit, and the video data display control unit.

(Controlled elements connected with controller 6 of driving simulator 1)

The controller 6 of the driving simulator 1 is connected with the projector 7 and any other control element (not illustrated). The controller 6 outputs their control signals to the projector 7 and the like. The projector 7 displays (projects) an image (video) on the screen 8.

(Functions of controller 6 of driving simulator 1)

The controller (driving simulation program) 6 of the driving simulator 1 has functions to execute processing in accordance with input signals from the signal output elements and output a control signal to each control element. Specifically, the controller 6 has functions below.

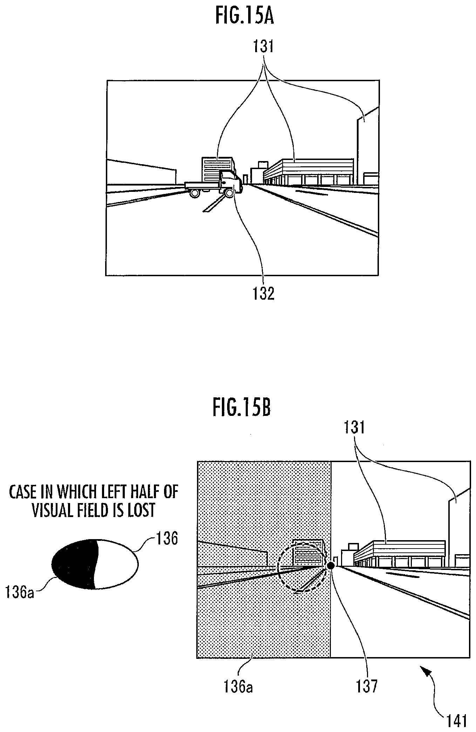

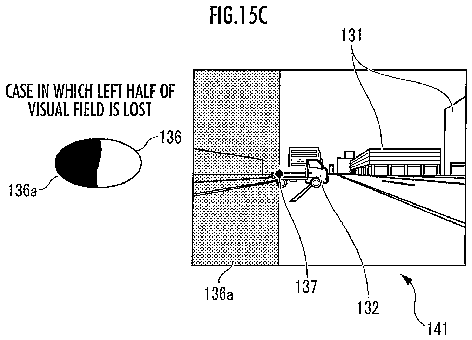

FIG.s 15A to 15C are explanatory diagrams of an exemplary video displayed at the driving simulator 1, FIG. 15A is an explanatory diagram of the video without visual field narrowing, FIG. 15B is an explanatory diagram of the video in a state in which the line of sight is positioned at the center and the left half of the visual field is lost, and FIG. 15C is an explanatory diagram of the video in which the line of sight has moved to the left side as compared to FIG. 15B.

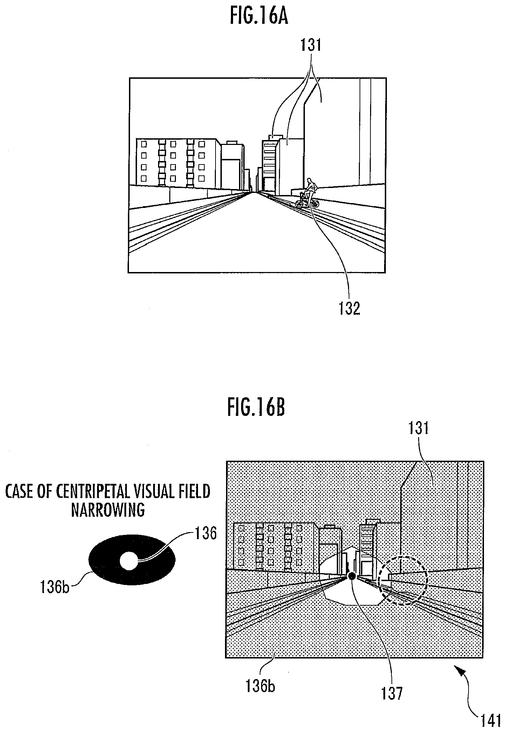

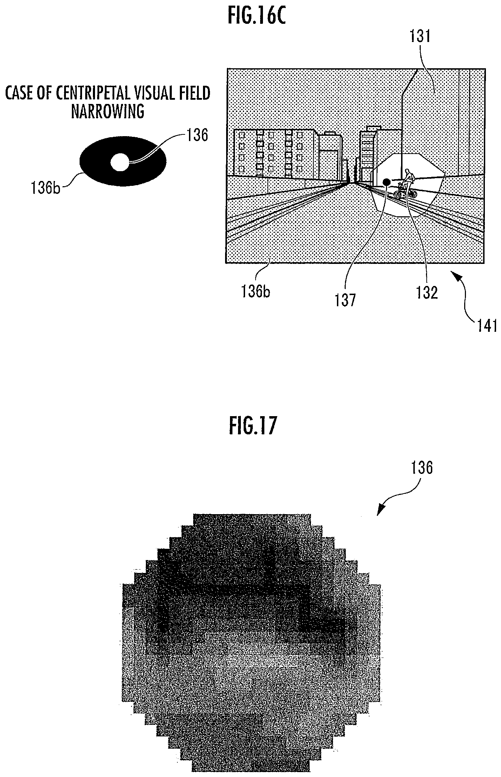

FIG.s 16A to 16C are explanatory diagrams of another exemplary video displayed at the driving simulator 1, FIG. 16A is an explanatory diagram of the video in a state without visual field narrowing, FIG. 16B is an explanatory diagram of the video in a state in which the line of sight is positioned at the center and a loss occurs except at a central part of the visual field, and FIG. 16C is an explanatory diagram of the video in which the line of sight has moved to the right side as compared to FIG. 16B.

C1: Simulator video storage unit

A simulator video storage unit C1 stores a video of the driving simulator 1. In FIG.s 15A and 16A, the simulator video storage unit C1 of the second embodiment stores a video including a background part 131 in which fixed objects such as a building and a road are visualized and a non-background part 132 in which moving objects such as a vehicle, a motorcycle, and a pedestrian moving in the background part 131 are visualized. As described in Patent Literature 2 or the like, various kinds of conventionally well-known videos may be used as the video of the driving simulator 1, and thus detailed description thereof will be omitted.

C2: Visual field distribution data storage unit (visual field narrowing information storage unit)

A visual field distribution data storage unit C2 as an exemplary visual field narrowing information storage unit stores visual field distribution data. In FIG.s 15A to 15C and 16A to 16C, the visual field distribution data storage unit C2 of the embodiment stores, as the distribution data (visual field narrowing information) of the visual field, for example, information in which a left half 136a of a visual field 136 is lost as illustrated in FIG.s 15B and 15C and information in which a non-central part 136b of the visual field 136 is lost (centripetal visual field narrowing) as illustrated in FIG.s 16B and 16C.

FIG. 17 is an explanatory diagram of exemplary visual field information. The visual field narrowing information is not limited to those illustrated in FIG.s 15B, 15C, 16B, and 16C. The positions, number, and sizes of lost regions are optionally changeable in accordance with a visual field narrowing situation to be experienced. The present invention is not limited to binary information such as a lost part (invisible part) and a visible part. In FIG. 17, sensitivity distribution data of a retina at a determined place, which is measured by an automatic visual field meter from a patient with a visual field loss or the like is stored as exemplary visual field distribution data. Visual field narrowing can be detected by using a well-known visual field meter that is commercially available, and a visual field situation including visual field narrowing can be detected by an optional device and an optional method.

In the example illustrated in FIG. 17, among pixel regions in the visual field 136, a dark black part is a part at which sensitivity is low and that is hardly visible, and a light black part (part close to white) is a part at which sensitivity is high and that is visible. In addition, a part (gray part) having a density between those of the dark and light black parts is a part at which sensitivity is intermediate. In an actual visual field loss, a binary situation in which visibility is obtained or not is unlikely to occur, but a clearly visible part (high sensitivity part), a completely invisible part (low sensitivity part), and a slightly visible part (middle sensitivity part) exist in some cases. Thus, it is possible to use such sensitivity distribution data.

Sensitivity levels (sensitivity classifications) are optionally changeable in accordance with the specifications, designing, and the like of the driving simulator 1 and may be two levels or multiple levels of three or more levels. In addition, sensitivity distribution fineness (pixel size) is optionally changeable in accordance with the designing, the specifications, and the like.

Thus, the visual field narrowing information of the second embodiment is produced based on visual field information detected by the automatic visual field meter in accordance with sensitivity classifications (levels and fineness) predetermined based on the designing and the like and is stored in the visual field distribution data storage unit C2 in advance.

The visual field narrowing information may be the visual field narrowing information of the user who uses the driving simulator 1, or may be the visual field narrowing information of another person or information of a typical visual field narrowing state with which an unimpaired person can experience driving in the visual field narrowing state.

C3: Sight line sensing unit

A sight line sensing unit C3 senses the line of sight of the user M based on a result of detection by the sight line detection device 10. The sight line sensing unit C3 senses the line of sight of the user M as illustrated with a sight line position (viewpoint) 137 in FIG.s 15B, 15C, 16B, and 16C.

C4: Steering wheel operation amount sensing unit

A steering wheel operation amount sensing unit C4 detects the amount of operation of the steering wheel 3 by the user M based on a result of sensing by the steering angle sensor 11.

C5: Acceleration operation amount sensing unit

An acceleration operation amount sensing unit C5 detects the amount of operation (step-in) of the acceleration pedal 4 by the user M based on a result of sensing by the acceleration sensor 12.

C6: Brake operation amount sensing unit

A brake operation amount sensing unit C6 detects the amount of operation (step-in) of the brake pedal 5 by the user M based on a result of sensing by the brake sensor 13.

In the present embodiment, the steering wheel 3, the acceleration pedal 4, and the brake pedal 5 correspond to the operation unit, and the steering angle sensor 11, the acceleration sensor 12, and the brake sensor 13 correspond to the operation state acquisition unit.

C7: Narrowing video production unit

A narrowing video production unit C7 produces a narrowing state video 141 (FIG.s 15B, 15C, 16B, and 16C) by fabricating a video in the simulator video storage unit C1 based on the data of visual field distribution in the visual field 136 centered at the sight line position (viewpoint) 137. The narrowing video production unit C7 of the second embodiment produces and updates the narrowing state video so that traveling is made in a virtual space of the driving simulator 1 in accordance with the sight line position 137 of the user M, the visual field distribution data, and the operation amounts of the steering wheel 3, the acceleration pedal 4, and the brake pedal 5. In FIG.s 15A to 15C and 16A to 16C, videos of loss regions centered at a sight line position (viewpoint) 137 are changed (fabricated) based on the visual field 136 with which the left half 136a and the non-central part 136b are lost in the videos (FIG. s 15A and 16A) of the driving simulator 1.

In this case, to reproduce filling-in, the narrowing state video 141 (FIG. 15B or 16B) is produced by fabricating the video so that the background part 131 is not fabricated but part of the non-background part 132, which overlaps a lost region 136a or 136b is deleted. Then, as the sight line position 137 moves, the loss region 136a or 136b is varied in accordance with the sight line position 137 as illustrated in FIG.s 15C and 16C, and the video is updated with the narrowing state video (visual field narrowing video) 141 in which the non-background part (pickup truck or motorcycle) 132 that no longer overlaps the varied loss region 136a or 136b is not deleted.

When the non-background part (pickup truck or motorcycle) exists at a plurality of sensitivity parts (for example, when the front half of the pickup truck is positioned at a high sensitivity part and the rear half is positioned at a low sensitivity part), transparency and contrast may be changed at an optional place on this object.

The orientations of a video 131 or 132 of the driving simulator 1 vary in the right-left direction in accordance with the operation amount of the steering wheel 3, speed is calculated so that forward travel and acceleration are performed in accordance with the operation amount of the acceleration pedal 4 and deceleration is performed in accordance with the operation amount of the brake pedal 5, and the video of the driving simulator 1 are updated. The updating of the video in accordance with operation of the steering wheel 3, acceleration, and brake is same as that for the conventionally well-known driving simulator 1, and thus further detailed description thereof will be omitted. Then, the visual field narrowing video 141 is produced and updated based on the video of the driving simulator 1 updated in accordance with operation of the steering wheel 3 and the like, the sight line position 137, and the visual field distribution data.

C8: Video display unit

A video display unit C8 projects (displays) the visual field narrowing video 141 produced by the narrowing video production unit C7 onto the screen 8 through the projector 7.

(Description of flowchart)

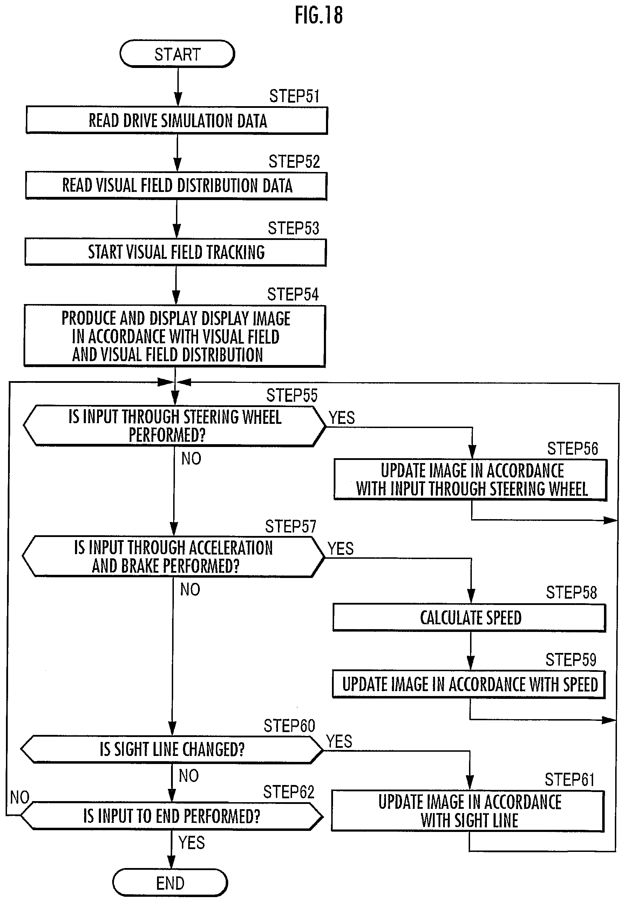

FIG. 18 is an explanatory diagram of a flowchart of visual field narrowing video display processing of the second embodiment. Processing at each STEP in the flowchart in FIG. 18 is performed in accordance with a computer program stored in the controller 6 of the driving simulator 1. This processing is executed in parallel various kinds of other processing at the driving simulator 1. The flowchart illustrated in FIG. 18 is started upon activation (power source input) of the driving simulator 1.

At STEP51 in FIG. 18, the data (videos) 131 and 132 of the driving simulator 1 are read. Then, the process proceeds to STEP52.

At STEP52, data of visual field distribution (visual field) 136 is read. Then, the process proceeds to STEP53. At STEP53, detection of the sight line position 137 is started. Then, the process proceeds to STEP54.

At STEP54, a display image (visual field narrowing video 141) and produced and displayed in accordance with the line of sight and data of visual field distribution 136. Then, the process proceeds to STEP55.

At STEP55, it is determined whether an input through the steering wheel 3 is performed. The process proceeds to STEP56 in a case of YES, or the process proceeds to STEP57 in a case of NO.

**[0134]** At STEP56, the display image (visual field narrowing video 141) is updated in accordance with the input (operation amount) through the steering wheel 3. Then, the process returns to STEP55.

At STEP57, it is determined whether an input through the acceleration pedal 4 and the brake pedal 5 is performed. The process proceeds to STEP58 in a case of YES, or the process proceeds to STEP60 in a case of NO.

**[0136]** At STEP58, a travel speed in the virtual space of the driving simulator 1 is calculated. Then, the process proceeds to STEP59. At STEP59, the image (visual field narrowing video 141) is updated in accordance with the speed. Then, the process returns to STEP55.

At STEP60, it is determined whether the sight line position 137 is varied. The process proceeds to STEP61 in a case of YES, or the process proceeds to STEP62 in a case of NO.

**[0138]** At STEP61, the image (visual field narrowing video 141) is updated in accordance with the variation of the sight line position 137. Then, the process returns to STEP55. At STEP62, it is determined whether an input to end the driving simulator 1 is performed. The process returns to STEP55 in a case of NO, or the driving simulator 1 is ended in a case of YES.

(Effects of second embodiment)

In the driving simulator 1 of the second embodiment having the above-described configuration, a visual field narrowing video 141 is produced in accordance with data of the visual field (visual field region) 136 with visual field narrowing. The visual field narrowing video 141 displays a video in a visual field narrowing state so that the user M having an unimpaired visual field can experience driving in the visual field narrowing state. Accordingly, driving in a state in which a pickup truck, a two-wheel vehicle, or the like cannot be seen as illustrated in FIG.s 15B and 16B can be experienced, and thus influence of visual field narrowing on driving can be experienced. This leads to edification and enlightenment that driving in the visual field narrowing state is dangerous.

In particular, in the driving simulator 1 of the second embodiment, when the non-background part 132 overlaps the loss regions 136a and 136b, the non-background part 132 is deleted but the background part 131 is not deleted. Thus, it is possible to reproduce the state of filling-in. Accordingly, it is possible to reproduce a state closer to the actual visual field narrowing state than a case in which filling-in is not reproduced.

In the driving simulator 1 of the second embodiment, the sight line position 137 is detected, the loss regions 136a and 136b are moved in accordance with variation of the sight line position 137, and the visual field narrowing image 141 is updated. Thus, the visual field narrowing image 141 is updated when the line of sight is moved even without moving the head unlike a case in which pin-hole glasses are used. Accordingly, it is possible to reproduce a state closer to the actual driving state with visual field narrowing than a case in which pin-hole glasses are used.

In addition, in the visual field region 136 as illustrated in FIG. 17, it is possible to reproduce a state closer to the actual visual field narrowing state by producing the visual field narrowing image 141 by using visual field data having a sensitivity different for each pixel so that, for example, a video at a high sensitivity part is brightened and a video at a low sensitivity part is darkened. In other words, the luminance may be changed at both the background part 131 and the non-background part 132 or only at the non-background part 132 in accordance with sensitivity.

For example, the transparency of an object (the non-background part 132) such as a person or a car may be changed in accordance with the degree of sensitivity at a visual field loss part. Specifically, an object at a high sensitivity part may be displayed in a hardly transparent manner, and an object at a low sensitivity part may be displayed in a nearly transparent manner.

(Modifications)

Although the second embodiment of the present invention is described above in detail, the present invention is not limited to the second embodiment but may be changed in various manners within the scope of the present invention recited in the claims. Modifications (H01) to (H06) of the present invention are described below.

(H01) The second embodiment exemplarily describes a configuration applied to the driving simulator 1 of an automobile, but the present invention is not limited thereto. For example, the present invention is also applicable to a flight simulator with which airplane maneuver can be experienced, the driving simulator 1 with which two-wheel vehicle driving can be experienced, a simulator with which railway vehicle maneuver can be experienced, and a simulator with which walking of a pedestrian having an impaired visual field can be experienced.

(H02) The second embodiment exemplarily describes, as the configuration of the driving simulator 1, a configuration including the projector 7 and the screen 8, but the configuration may be changed to a configuration in which display is performed on a display device such as a television or a monitor or may be changed to a display device of a type that is mounted on the user M, such as a head-mounted display.

(H03) The present invention is not limited to a configuration exemplarily described as the sight line detection device 10 in the second embodiment but may have a glasses-type configuration. When a head-mounted display is used, the sight line detection device 10 may be built in the head-mounted display.

(H04) The second embodiment exemplarily describes a configuration in which the steering wheel 3, the acceleration pedal 4, and the brake pedal 5 are used as exemplary input part, but the present invention is not limited thereto. An input part such as a clutch pedal, a parking brake, or a direction indicator may be added.

(H05) The second embodiment exemplarily describes a configuration in which a video of the background part 131 in video data of the driving simulator 1 including the background part 131 and the non-background part 132 is produced, but the present invention is not limited thereto. For example, a video may be displayed in which the non-background part 132 produced in a real image is placed over the background part 131 as an image captured by a camera or an actually visible image.

(H06) The background part 131 in the second embodiment is a fixed object such as a building, but the present invention is not limited thereto. For example, an object that changes to blue, yellow, and red through temporal transition like a traffic light may be treated as a moving object instead of a fixed object. For example, when the lamps of a traffic light overlaps a loss region and cannot be recognized as passing is made through a traffic intersection with the traffic light, the traffic light (entire traffic light) is not complemented by filling-in, and a patient with a visual field loss wrongly recognizes the traffic intersection as a traffic intersection with no traffic light and ignores the traffic light as a result in some cases. Thus, an actual situation recognized by the patient can be simulated by treating the traffic light as a moving object and processing the traffic light as the non-background part 132.

Reference Signs List

1 driving simulator
3 steering wheel (operation unit)
4 acceleration pedal (operation unit)
5 brake pedal (operation unit)
6 controller (visual field loss information data storage unit, simulated video data storage unit, association video data production unit, video data display control unit, data production unit, association video data storage unit, dangerous state determination unit, dangerous state display unit, overlapping situation parameter acquisition unit, correlation model storage unit, driving danger degree determination unit, driving danger degree display unit)
7 projector (output interface)
8 screen (output interface)
10 sight line detection device (viewpoint acquisition unit)
11 steering angle sensor (operation state acquisition unit)
12 acceleration sensor (operation state acquisition unit)
13 brake sensor (operation state acquisition unit)
M user
O viewpoint of user
Xref danger index value (overlapping situation parameter)
131 video, background part
132 video, non-background part
136 visual field
137 viewpoint
141 narrowing video

**Claims**

1. A driving simulator with which vehicle driving is experienced in a simulated manner, the driving simulator comprising:

   an output interface;
   an operation unit operated by a user to drive a simulated vehicle;
   an operation state acquisition unit configured to acquire a state of operation of the operation unit by the user;
   a viewpoint acquisition unit configured to acquire a viewpoint of the user;
   a visual field loss information data storage unit configured to store visual field loss information data indicating a state of occurrence of a visual field loss of the user;
   a simulated video data storage unit configured to store simulated video data that visualizes a simulated travel environment;
   an association video data production unit configured to produce association video data in accordance with the state of operation of the operation unit by the user, the visual field loss information data, and the viewpoint of the user, the association video data being data in which the visual field loss information data and the simulated video data are associated with each other; and

a video data display control unit configured to execute video data display control to display the association video data on the output interface.

2. The driving simulator according to claim 1, wherein
the simulated video data includes a background part including a video of a fixed object, and a non-background part including a video of a moving object that moves in the background part, and
the association video data production unit produces the association video data by, in accordance with the state of operation of the operation unit by the user, the visual field loss information data, and the viewpoint of the user, displaying an image of the background part overlapping a region in which the visual field loss occurs and changing an image of the non-background part overlapping the region in which the visual field loss occurs.

3. The driving simulator according to claim 2, wherein the visual field loss information data is configured as information on sensitivity distribution of visibility in a visual field centered at the viewpoint.

4. The driving simulator according to claim 3, wherein the association video data production unit changes transparency and contrast of the image of the non-background part in accordance with the sensitivity distribution.

5. The driving simulator according to claim 1, wherein
the visual field loss information data is data in which the state of occurrence of the visual field loss of the user is associated with a visual field region of the user,
the association video data production unit includes
a simulated video display control unit configured to execute simulated video display control to display the simulated video data stored in the simulated video data storage unit on the output interface in accordance with the state of operation of the operation unit by the user, and
a data production unit configured to produce the association video data as data in which the viewpoint of the user acquired by the viewpoint acquisition unit, the visual field loss information data, and a video of an object in the simulated video data are associated with one another being centered at the viewpoint of the user in an identical video during execution of the simulated video display control,
the driving simulator further includes an association video data storage unit configured to store the association video data, and
the video data display control unit executes, as the video data display control, video playback control to perform playback display of the association video data on the output interface after end of the simulated video display control.

6. The driving simulator according to claim 5, further comprising:

a dangerous state determination unit configured to determine whether a simulated dangerous state of at least one of contact and precontact of the simulated vehicle with another object in a simulated travel environment has occurred during execution of the simulated video display control; and
a dangerous state display unit configured to display a result of the occurrence determination of the simulated dangerous state by the dangerous state determination unit on the output interface during execution or after end of the video playback control.

7. The driving simulator according to claim 5 or 6, further comprising:

an overlapping situation parameter acquisition unit configured to acquire an overlapping situation parameter indicating a state of occurrence of an overlapping situation in which an object in the simulated video data overlaps the region in which the visual field loss in the visual field loss information data occurs during execution of the simulated video display control;
a correlation model storage unit configured to store a correlation model indicating a correlation between the overlapping situation parameter and a danger degree indicating a probability that the simulated dangerous state of at least one of contact and precontact of the simulated vehicle with another object in a simulated travel environment occurs;
a driving danger degree determination unit configured to determine the danger degree of the user at vehicle driving by using the correlation model and the overlapping situation parameter of the user; and
a driving danger degree display unit configured to display a result of the determination of the danger degree at the vehicle driving by the driving danger degree determination unit on the output interface during execution or after end of the video playback control.

8. A video control device comprising:

an output interface;
a visual field loss information data storage unit configured to store visual field loss information data in which a state of occurrence of a visual field loss of a user is associated with a visual field region of the user;
a moving image video data storage unit configured to store a moving image video data including an object;
a moving image display control unit configured to execute moving image display control to display the moving image video data stored in the moving image video data storage unit on the output interface;
a viewpoint acquisition unit configured to acquire a viewpoint of the user during execution of the moving image display control;
an association video data storage unit configured to store, as association video data, data in which the viewpoint of the user, the visual field loss information data, and a video of the object in the moving image video data are associated with one another being centered at the viewpoint of the user in an identical video during execution of the moving image display control; and
a video playback control unit configured to execute video playback control to perform playback display of the association video data on the output interface after end of the moving image display control.

## FIG.1

## FIG.2

| | | |
|---|---|---|
| SIGHT LINE DETECTION DEVICE — 10 | | |
| STEERING ANGLE SENSOR — 11 | CONTROLLER — 6 | PROJECTOR — 7 |
| ACCELERATION SENSOR — 12 | | |
| BRAKE SENSOR — 13 | | |

## FIG.3

## FIG.4

SIMULATED TRAVEL CONTROL

```
              ┌──────────────┐
              │    START     │
              └──────┬───────┘
                     │
                     ▼                    STEP1
       ◁─────────────────────────────▷ ──── YES ──┐
       │        F_RUN = 1  ?          │            │
       ◁─────────────────────────────▷            │
                     │NO                           │
                     ▼                    STEP2     │
  NO ◁─────────────────────────────────▷          │
  │    │    IS START OPERATION EXECUTED? │         │
  │    ◁─────────────────────────────────▷         │
  │                  │YES                           │
  │                  ▼                  STEP3        │
  │    ┌────────────────────────────┐               │
  │    │         F_RUN ← 1          │               │
  │    └────────────────────────────┘               │
  │                  │◀───────────────────────────── ┘
  │                  ▼                  STEP4
  │    ┌────────────────────────────────┐
  │    │ EXECUTE SIMULATED VIDEO DISPLAY CONTROL │
  │    └────────────────────────────────┘
  │                  │
  │                  ▼                  STEP5
  │    ┌────────────────────────────┐
  │    │    EXECUTE ACOUSTIC CONTROL │
  │    └────────────────────────────┘
  │                  │
  │                  ▼                  STEP6
  │    ┌────────────────────────────┐
  │    │  STORE VISUAL FIELD VIDEO DATA │
  │    └────────────────────────────┘
  │                  │
  │                  ▼                  STEP7
  │    ┌────────────────────────────┐
  │    │    STORE OVERLAPPING TIME   │
  │    └────────────────────────────┘
  │                  │
  │                  ▼                  STEP8
  │    ┌────────────────────────────────┐
  │    │ STORE THE NUMBER OF DANGER OCCURRENCES │
  │    └────────────────────────────────┘
  │                  │
  │                  ▼                  STEP9
  │ NO ◁─────────────────────────────────▷
  ◀───│    HAS SIMULATED TRAVEL ENDED?   │
  │    ◁─────────────────────────────────▷
  │                  │YES
  │                  ▼                  STEP10
  │    ┌────────────────────────────┐
  │    │         F_RUN ← 0          │
  │    └────────────────────────────┘
  │                  │
  └──────────────────▼
              ┌──────────────┐
              │     END      │
              └──────────────┘
```

# FIG.5

## FIG.6

PLAYBACK DISPLAY CONTROL

FIG.7

FIG.8

## FIG.9

## FIG.10

## FIG.11

| Xref | $0 \leqq$ Xref $< X1$ | $X1 \leqq$ Xref $< X2$ | $X2 \leqq$ Xref |
|---|---|---|---|
| DANGER DEGREE AT DRIVING | LOW | INTERMEDIATE | HIGH |

## FIG.12

| THE NUMBER OF ACCIDENT OCCURRENCES | 1 |
|---|---|
| THE NUMBER OF NEAR-MISS OCCURRENCES | 5 |

## FIG.13

| VISUAL FIELD SENSITIVITY REGION | NON-SENSITIVITY REGION | LOW SENSITIVITY REGION | INTERMEDIATE SENSITIVITY REGION |
|---|---|---|---|
| OVERLAPPING RATIO(%) | 16 | 12 | 24 |
| DRIVING DANGER DEGREE | HIGH | | |

FIG.14

CONTROLLER — 6

C1
SIMULATOR VIDEO STORAGE UNIT

C2
VISUAL FIELD DISTRIBUTION DATA STORAGE UNIT

C3
SIGHT LINE SENSING UNIT

C4
STEERING WHEEL OPERATION AMOUNT SENSING UNIT

C5
ACCELERATION OPERATION AMOUNT SENSING UNIT

C6
BRAKE OPERATION AMOUNT SENSING UNIT

C7
NARROWING VIDEO PRODUCTION UNIT

C8
VIDEO DISPLAY UNIT

STEERING ANGLE SENSOR — 11 ◄--- STEERING WHEEL — 3

ACCELERATION SENSOR — 12 ◄--- ACCELERATION PEDAL — 4

BRAKE SENSOR — 13 ◄--- BRAKE PEDAL — 5

SIGHT LINE DETECTION DEVICE — 10

PROJECTOR — 7

## FIG.15A

## FIG.15B

CASE IN WHICH LEFT HALF OF
VISUAL FIELD IS LOST

FIG.15C

CASE IN WHICH LEFT HALF OF
VISUAL FIELD IS LOST

## FIG.16A

## FIG.16B

CASE OF CENTRIPETAL VISUAL FIELD NARROWING

## FIG.16C

CASE OF CENTRIPETAL VISUAL FIELD
NARROWING

131

136

136b

136b 137 132

141

## FIG.17

136

## FIG.18

START

STEP51
READ DRIVE SIMULATION DATA

STEP52
READ VISUAL FIELD DISTRIBUTION DATA

STEP53
START VISUAL FIELD TRACKING

STEP54
PRODUCE AND DISPLAY DISPLAY IMAGE
IN ACCORDANCE WITH VISUAL FIELD
AND VISUAL FIELD DISTRIBUTION

STEP55
IS INPUT THROUGH STEERING WHEEL
PERFORMED? — YES

NO

STEP56
UPDATE IMAGE IN ACCORDANCE
WITH INPUT THROUGH STEERING WHEEL

STEP57
IS INPUT THROUGH ACCELERATION
AND BRAKE PERFORMED? — YES

NO

STEP58
CALCULATE SPEED

STEP59
UPDATE IMAGE IN ACCORDANCE WITH SPEED

STEP60
IS SIGHT LINE CHANGED? — YES

NO

STEP62
NO — IS INPUT TO END PERFORMED?

STEP61
UPDATE IMAGE IN ACCORDANCE
WITH SIGHT LINE

YES

END

# FIG.19A

201

202

203

204

GREEN TRAFFIC LIGHT

## FIG.19B

201

202

203

RED TRAFFIC LIGHT

204

## FIG.20A

208

## FIG.20B

206

207

208

209

FIG.21A

FIG.21B

## INTERNATIONAL SEARCH REPORT

| International application No. |
| --- |
| PCT/JP2019/028221 |

**A. CLASSIFICATION OF SUBJECT MATTER**
Int.Cl. G09B9/052(2006.01)i, G06F3/01(2006.01)i, G09B19/00(2006.01)i

According to International Patent Classification (IPC) or to both national classification and IPC

**B. FIELDS SEARCHED**

Minimum documentation searched (classification system followed by classification symbols)
Int.Cl. G09B1/00-G09B29/14, A61B3/00-A61B3/18, G06F3/01

Documentation searched other than minimum documentation to the extent that such documents are included in the fields searched

| | |
| --- | --- |
| Published examined utility model applications of Japan | 1922-1996 |
| Published unexamined utility model applications of Japan | 1971-2019 |
| Registered utility model specifications of Japan | 1996-2019 |
| Published registered utility model applications of Japan | 1994-2019 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X<br>Y<br>A | JP 2018-45067 A (HONDA MOTOR CO., LTD.) 22 March 2018, paragraphs [0008], [0025]-[0087], fig. 1-9 (Family: none) | 1, 5, 8<br>6<br>2-4, 7 |
| Y<br>A | 山崎 裕介 ほか，初心運転者に対する危険予測訓練法の効果検証，ヒューマンインタフェースシンポジウム 2014 論文集，09 September 2014, pp. 521-524, (YAMAZAKI, Yusuke et al., Proceedings of the Human Interface Symposium 2014), non-official translation (Verification of effectiveness of risk prediction training for beginner drivers) | 6<br>1-5, 7-8 |

☒ Further documents are listed in the continuation of Box C.  ☐ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 04.09.2019 | 17.09.2019 |

| Name and mailing address of the ISA/ | Authorized officer |
| --- | --- |
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.

PCT/JP2019/028221

C (Continuation).  DOCUMENTS CONSIDERED TO BE RELEVANT

| Category* | Citation of document, with indication, where appropriate, of the relevant passages | Relevant to claim No. |
|---|---|---|
| A | JP 2008-139553 A (NATIONAL AGENCY FOR AUTOMOTIVE SAFETY & VICTIM'S AID) 19 June 2008, entire text, all drawings (Family: none) | 1-8 |
| A | JP 2010-2714 A (TOYOTA MOTOR CORPORATION) 07 January 2010, paragraphs [0012]-[0034], [0063]-[0068], fig. 1-5, 9 (Family: none) | 1-8 |
| A | JP 2013-61597 A (JAPAN AUTOMOBILE RESEARCH INSTITUTE) 04 April 2013, entire text, all drawings (Family: none) | 1-8 |
| A | US 2014/0220513 A1 (HARKNESS, R.) 07 August 2014, entire text, all drawings (Family: none) | 1-8 |
| A | JP 2015-230632 A (DAI NIPPON PRINTING CO., LTD.) 21 December 2015, entire text, all drawings (Family: none) | 1-8 |
| A | JP 2018-10310 A (SONY CORPORATION) 18 January 2018, entire text, all drawings (Family: none) | 1-8 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017217226 A

- JP 2009174879 A